# EUROPEAN PATENT APPLICATION

(11) **EP 4 270 470 A1**
(43) Date of publication of application: **01.11.2023**
(21) Application number: 23169536.2
(22) Date of filing: 24.04.2023
(51) Int. Cl.: H01L 23/29, H01L 23/373

(54) **MOLDING COMPOUND THERMAL ENHANCEMENT UTILIZING GRAPHENE OR GRAPHITE MATERIALS**

(30) Priority: 26.04.2022 US 202263334980 P; 10.04.2023 US 202318297843
(71) Applicant: Qorvo US, Inc., Greensboro, NC 27409 (US)
(72) Inventor: BOJKOV, Christo, Greensboro, NC 27409 (US); MELIANE, Walid, Greensboro, NC 27409 (US); ESSAR, Matthew, Greensboro, NC 27409 (US); BALUT, Brian P., Greensboro, NC 27409 (US)
(74) Representative: D Young & Co LLP

(57) **Abstract**

The present disclosure relates to a semiconductor package with a thermally enhanced molding compound. The disclosed semiconductor package includes a module carrier having an upper surface, a die formed over the upper surface of the module carrier, and a thermally enhanced molding compound component formed over the upper surface of module carrier to encapsulate the die. Herein, the thermally enhanced molding compound is formed from a molding compound mixed with a thermal additive and has no air pockets or voids. The thermal additive includes a number of carbon flakes or a number of carbon spherical particles. The thermal additive has a thermal conductivity larger than 450 W/m·K and an electrical resistivity larger than 90 µΩ.cm. In one embodiment, the thermal additive includes a number of graphene flakes, a number of graphene particles, a number of graphite flakes, or a number of graphite particles.

## Description

### Related Applications

This application claims the benefit of provisional patent application serial number 63/334,980, filed April 26, 2022, and patent application serial number 18/297,843, filed 10 April 2023, the disclosure of which are hereby incorporated herein by reference in its entirety.

### Field of the Disclosure

The present disclosure relates to a semiconductor package with a thermally enhanced molding compound utilizing one or more thermal additives, and more particularly utilizing graphene or graphite materials.

### Background

With the current popularity of portable communication devices and developed semiconductor fabrication technology, high speed and high-performance transistors are more densely integrated on semiconductor dies. Consequently, the amount of heat generated by the semiconductor dies increases significantly due to the large number of transistors integrated on the semiconductor dies, the large amount of power passing through the transistors, and the high operation speed of the transistors. Accordingly, it is desirable to package the semiconductor dies in a configuration for better heat dissipation.

Conventional molding compounds currently used in the packaging industry are known to have very limited thermal conductivity in the range below ~1 W/m·K. Thermal additives, such as silicon oxide, alumina, boron nitride, aluminum nitride, gold, or cooper, are introduced to be added into the molding compounds to enhance the thermal performance. However, these thermal additives may cause moisture problems (i.e., the molding compounds may absorb undesired moisture due to the added thermal additives), which may result in air pockets or voids in the molding compounds during reliability testing (i.e., the moisture is gasified). In addition, the existing thermal additives may increase package weight (i.e., the mass of the thermal additive may be greater than the conventional molding compound with a same volume), increase package cost, and/or reduce electrical resistivity.

### Summary

Particular aspects are set out in the appended independent claims. Various optional embodiments are set out in the dependent claims.

Some implementations of the present disclosure may accommodate the increased heat generation of high-performance dies, limit moisture absorption into a package, and retain a high electrical resistivity without increasing the cost or weight of the final package, through use of an improved molding compound for a package to enhance heat dissipation performance.

The present disclosure relates to a semiconductor package with a thermally enhanced molding compound. The disclosed semiconductor package includes a module carrier having an upper surface, a die formed over the upper surface of the module carrier, and a thermally enhanced molding compound formed over the upper surface of module carrier to encapsulate the die. Herein, the thermally enhanced molding compound is formed from a molding compound mixed with a thermal additive and has no air pockets or voids. The thermal additive includes a number of carbon flakes or a number of carbon spherical particles. The thermal additive has a thermal conductivity larger than 450 W/m·K and an electrical resistivity larger than 90 µΩ.cm.

In one embodiment of the disclosed semiconductor package, the thermal additive includes a number of graphene flakes.

In one embodiment of the disclosed semiconductor package, the thermal additive includes a number of graphene particles.

In one embodiment of the disclosed semiconductor package, the thermal additive includes a number of graphite flakes.

In one embodiment of the disclosed semiconductor package, the thermal additive includes a number of graphite particles.

In one embodiment of the disclosed semiconductor package, the thermal additive includes the number of carbon flakes, each of which has a maximum dimension of up to 50 µm in three dimensions.

In one embodiment of the disclosed semiconductor package, each carbon flake has a maximum dimension between 10 µm and 20 µm.

In one embodiment of the disclosed semiconductor package, the thermal additive includes the number of carbon spherical particles, each of which has a maximum dimension of up to 30 µm in three dimensions.

In one embodiment of the disclosed semiconductor package, each carbon spherical particle has a maximum dimension between 10 µm and 20 µm.

In one embodiment of the disclosed semiconductor package, the die is produced from Gallium Nitride (GaN) and/or Gallium Arsenide (GaAs).

In one embodiment of the disclosed semiconductor package, the die is a wire-bonding die.

According to one embodiment, the disclosed semiconductor package further includes a polymer layer directly and fully covering the die. Herein, the thermally enhanced molding compound is in contact with the polymer layer.

In one embodiment of the disclosed semiconductor package, the polymer layer has a thickness up to 10 µm and is configured to protect the die and release stress of the die.

In one embodiment of the disclosed semiconductor package, the polymer layer is formed of poly benzo butene (BCB), poly benzo oxazol (PBO), or polyimide (PI).

In one embodiment of the disclosed semiconductor package, the die is a flip-chip die including a number of interconnections protruding from a lower surface of the die towards the upper surface of the module carrier.

According to one embodiment, the disclosed semiconductor package further includes an underfilling layer that resides over the upper surface of the module carrier, encapsulates sides of each interconnect, and underfills the die between the lower surface of the die and the upper surface of the module carrier.

In one embodiment of the disclosed semiconductor package, the underfilling layer is a portion of the thermally enhanced molding compound.

In one embodiment of the disclosed semiconductor package, the molding compound itself has a thermal conductivity between 0.8 W/m·K -1.0 W/m·K.

In one embodiment of the disclosed semiconductor package, the molding compound is an organic epoxy resin.

In one embodiment of the disclosed semiconductor package, within the thermally enhanced molding compound, the thermal additive is dispersed throughout the molding compound with a varied density.

In another aspect, any of the foregoing aspects individually or together, and/or various separate aspects and features as described herein, may be combined for additional advantage. Any of the various features and elements as disclosed herein may be combined with one or more other disclosed features and elements unless indicated to the contrary herein.

Those skilled in the art will appreciate the scope of the present disclosure and realize additional aspects thereof after reading the following detailed description of the illustrative embodiments in association with the accompanying drawing figures.

### Brief Description of the Drawing Figures

The accompanying drawing figures incorporated in and forming a part of this specification illustrate several aspects of the disclosure, and together with the description serve to explain the principles of the disclosure.

Figures 1A-1C show an example semiconductor package with a thermally enhanced molding compound according to one embodiment of the present disclosure.

Figures 2-3 show an alternative semiconductor package according to one embodiment of the present disclosure.

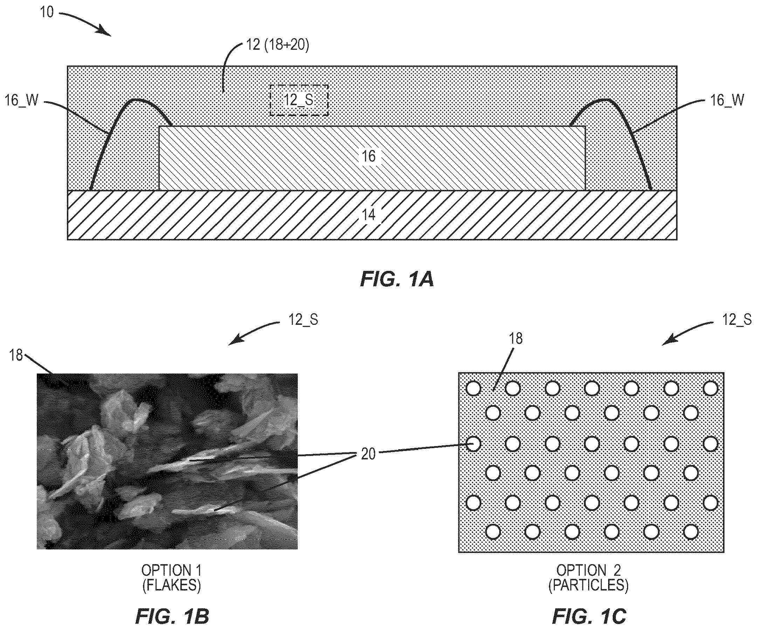

It will be understood that for clear illustrations, Figures 1A-3 may not be drawn to scale.

### Detailed Description

The embodiments set forth below represent the necessary information to enable those skilled in the art to practice the embodiments and illustrate the best mode of practicing the embodiments. Upon reading the following description in light of the accompanying drawing figures, those skilled in the art will understand the concepts of the disclosure and will recognize applications of these concepts not particularly addressed herein. It should be understood that these concepts and applications fall within the scope of the disclosure and the accompanying claims.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of the present disclosure. As used herein, the term "and/or" includes any and all combinations of one or more of the associated listed items.

It will be understood that when an element such as a layer, region, or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. Likewise, it will be understood that when an element such as a layer, region, or substrate is referred to as being "over" or extending "over" another element, it can be directly over or extend directly over the other element or intervening elements may also be present. In contrast, when an element is referred to as being "directly over" or extending "directly over" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

Relative terms such as "below" or "above" or "upper" or "lower" or "horizontal" or "vertical" may be used herein to describe a relationship of one element, layer, or region to another element, layer, or region as illustrated in the Figures. It will be understood that these terms and those discussed above are intended to encompass different orientations of the device in addition to the orientation depicted in the Figures.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including" when used herein specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this disclosure belongs. It will be further understood that terms used herein should be interpreted as having a meaning that is consistent with their meaning in the context of this specification and the relevant art and will not be interpreted in an idealized or overly formal sense unless expressly so defined herein.

Embodiments are described herein with reference to schematic illustrations of embodiments of the disclosure. As such, the actual dimensions of the layers and elements can be different, and variations from the shapes of the illustrations as a result, for example, of manufacturing techniques and/or tolerances, are expected. For example, a region illustrated or described as square or rectangular can have rounded or curved features, and regions shown as straight lines may have some irregularity. Thus, the regions illustrated in the figures are schematic and their shapes are not intended to illustrate the precise shape of a region of a device and are not intended to limit the scope of the disclosure. Additionally, sizes of structures or regions may be exaggerated relative to other structures or regions for illustrative purposes and, thus, are provided to illustrate the general structures of the present subject matter and may or may not be drawn to scale. Common elements between figures may be shown herein with common element numbers and may not be subsequently re-described.

The present disclosure relates to a semiconductor package with a thermally enhanced molding compound utilizing thermal additives, and more particularly utilizing graphene or graphite materials. Figure 1A shows an example semiconductor package 10 with a thermally enhanced molding compound 12 according to some embodiments of the present disclosure. For the purpose of this illustration, besides the thermally enhanced molding compound 12, the semiconductor package 10 also includes a module carrier 14 and a wire-bonding die 16 with wires 16_W. In different applications, the semiconductor package 10 may include multiple wire-bonding dies and/or other electrical components (not shown).

In detail, the module carrier 14 may be formed from a laminate, a wafer level fan out (WLFO) carrier, a lead frame, a ceramic carrier, or the like. The wire-bonding die 16 is formed over an upper surface of the module carrier 14, while the wires 16_W are configured to electrically connect the wire-bonding die 16 to the module carrier 14 (e.g., the wires 16_W extend from an upper surface of the wire-bonding die 16 to the upper surface of the module carrier 14).
The wire-bonding die 16 may be produced from Gallium Nitride (GaN) and/or Gallium Arsenide (GaAs) for high speed and high power applications.

The thermally enhanced molding compound 12 resides over the upper surface of the module carrier 14 and encapsulates the wire-bonding die 16 with the module carrier 14. Figures 1B and 1C illustrate internal details of the thermally enhanced molding compound 12 (e.g., within a section 12_S of the thermally enhanced molding compound 12). The thermally enhanced molding compound 12 is formed from a molding compound 18 mixed with a thermal additive 20. Herein, the molding compound 18 itself may have a thermal conductivity between 0.8 W/m·K -1.0 W/m·K. One example material used to form the molding compound 18 is an organic epoxy resin. The thermal additive 20 may have a thermal conductivity larger than 450 W/m·K and an electrical resistivity larger than 90 µΩ.cm. In one embodiment, the thermal additive 20 may be formed of a graphene material or a graphite material. Table 1 shows thermal and electrical features of both graphene and graphite.

**Table 1**

| *Thermal Additive* | *Electrical Resistivity* | *Thermal Conductivity* |
|---|---|---|
| *Graphene* | *∼100 µΩ.cm* | *∼4800 W*/*m*·*K* |
| *Graphite* | *∼1000 µΩ.cm* | *∼470 W*/*m*·*K* |

When comparing the thermal conductivity of graphene/graphite with the thermal conductivity of organic epoxy resin, it is clear that the thermally enhanced molding compound 12, which is formed from the molding compound 18 mixed with the thermal additive 20, definitely has a higher thermal conductivity than the molding compound 18. Furthermore, since the thermal conductivity of graphene and the thermal conductivity of graphite are at least hundreds times higher than the thermal conductivity of organic epoxy resin, a relatively low density of the thermal additive 20 in the thermally enhanced molding compound 12 may still lead to a significant enhancement of the thermal cooling effect to the wire-bonding die 16 compared to the molding compound 18 itself. In one embodiment, the average thermal conductivity of the thermally enhanced molding compound 12 may be more than 400 times greater than the thermal conductivity of the molding compound 18.

In addition, the thermal additive 20 does not include any metal or silicon and may not add significant mass to the thermally enhanced molding compound 12 compared to the molding compound 18 in a same volume. In this embodiment, the thermally enhanced molding compound 12 is directly in contact with the wires 16_W of the wire-bonding die 16, therefore a high electrical resistivity of the thermally enhanced molding compound 12 is required (e.g., non-electrical conductivity), otherwise the electrical performance of the wire-bonding die 16 will be inaccurate.

As illustrated in Figure 1B, the thermal additive 20 includes a number of flakes, each of which has a maximum dimension up to 50 µm in three dimensions (e.g., the maximum dimension is between 5 µm and 50 µm, or preferably between 10 µm and 20 µm), and a minimum dimension (i.e., a thickness of one carbon flake) of at least 1 µm in the three dimensions (e.g., the minimum dimension is between 1 µm and 5 µm). In one embodiment, the thermal additive 20 may include carbon flakes, such as graphene flakes or graphite flakes. Each graphene flake/graphite flake may have a different size and/or a different shape.

In some applications, the thermal flake additive 20 (e.g., the graphene flakes or graphite flakes) may be dispersed throughout the molding compound 18 with a substantially uniform density and a varied density (not shown). For instance, the closer to the wire-bonding die 16, the greater the density of the thermal flake additive 20 (i.e., the density of the thermal flake additive 20 in a first portion of the thermally enhanced molding compound 12, which is next to the upper surface of the wire-bonding die 16, is greater than the density of the thermal flake additive 20 in a second portion of the thermally enhanced molding compound 12, which is located at a top of the semiconductor package 10 and relatively far away from the wire-bonding die 16). In some applications, the thermal flake additive 20 (e.g., the graphene flakes or graphite flakes) may be dispersed throughout the molding compound 18 with a substantially uniform density.

In some applications, the thermal flake additive 20 (e.g., the graphene flakes or graphite flakes) may only be dispersed in one portion of the molding compound 18 but not throughout the entire molding compound 18 (not shown). For instance, the thermal flake additive 20 is only dispersed in the first portion of the molding compound 18, which is next to the upper surface of the wire-bonding die 16, while no thermal flake additive 20 is dispersed in the second portion of the molding compound 18, which is located at the top of the semiconductor package 10 and relatively far away from the wire-bonding die 16 (i.e., the density of the thermal flake additive 20 in the first portion of the thermally enhanced molding compound 12 is non-zero, while the density of the thermal flake additive 20 in the second portion of the thermally enhanced molding compound 12 is zero).

As illustrated in Figure 1C, the thermal additive 20 includes a number of spherical particles, each of which has a maximum dimension up to 30 µm in the three dimensions (e.g., between 1 µm and 30 µm, or preferably between 10 µm and 20 µm). In one embodiment, the thermal additive 20 may include carbon spherical particles, such as graphene particles or graphite particles. Each graphene particle/graphite particle may have a different size or a substantially same size.

Similar to the thermal additive with the flake configuration, in some applications, the thermal particle additive 20 (e.g., the graphene particles or graphite particles) may be dispersed throughout the molding compound 18 with a substantially uniform density or a varied density (e.g., the closer to the wire-bonding die 16, the greater the density of the thermal particle additive 20, not shown). In some applications, the thermal particle additive 20 (e.g., the graphene particles or graphite particles) may be dispersed throughout the molding compound 18 with a substantially uniform density.

In addition, the thermal particle additive 20 (e.g., the graphene particles or graphite particles) may only be dispersed in one portion of the molding compound 18 but not throughout the entire molding compound 18 (not shown). For instance, the thermal particle additive 20 is only dispersed in the first portion of the molding compound 18, which is next to the upper surface of the wire-bonding die 16, while no thermal particle additive 20 is dispersed in the second portion of the molding compound 18, which is located at the top of the semiconductor package 10 and relatively far away from the wire-bonding die 16.

Regardless of the flake configuration or the spherical configuration, the density of the thermal additive 20 within the thermally enhanced molding compound 12 is dependent on the application of the semiconductor package 10 (in weight, cost, thermal performance, and electrical resistivity aspects). For instance, the density of the thermal additive 20 within the thermally enhanced molding compound 12 may be between 1 g/cm³ and 30 g/cm³. Regardless of the flake configuration or the spherical configuration of the thermal additive 20, moisture is limited to be absorbed into the thermally enhanced molding compound 12, and in consequence, there will be no or a neglected number of air pockets or voids formed in the thermally enhanced molding compound 12 (e.g., when the semiconductor package 10 is baked during reliability testing). Therefore, the wire-bonding die 16 is fully protected by the thermally enhanced molding compound 12.

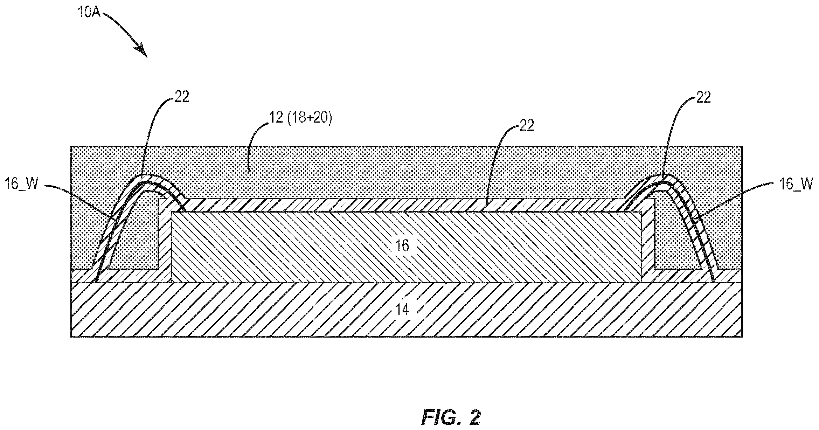

Figure 2 provides an alternative semiconductor package 10A according to some embodiments of the present disclosure. Compared to the semiconductor package 10, the alternative semiconductor package 10A further include a polymer layer 22, which fully and directly covers the wire-bonding die 16 (including covering the wires 16_W). The polymer layer 22 has a thickness up to 10 µm and is configured to protect the wire-bonding die 16 and release stress of the wire-bonding die 16. The polymer layer 22 may be formed of poly benzo butene (BCB), poly benzo oxazol (PBO), or polyimide (PI). In some applications, the polymer layer 22 also covers portions of the upper surface of the module carrier 14, which are not covered by the wire-bonding die 16. The thermally enhanced molding compound 12 still encapsulates the wire-bonding die 16, but is not in direct contact with the wire-bonding die 16. Herein, the thermally enhanced molding compound 12 is in contact with the polymer layer 22. Within the thermally enhanced molding compound 12 of the alternative semiconductor package 10A, the thermal additive 20 may be dispersed throughout the molding compound 18 with a substantially uniform density or a varied density, or the thermal additive 20 may only be dispersed in portions of the molding compound 18 as described above.

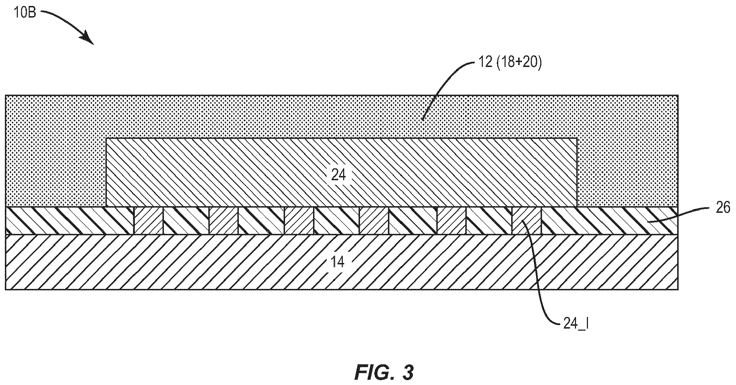

In some applications, one semiconductor package includes one or more flip-chip dies instead of a wire-bonding die. Figure 3 provides a second alternative semiconductor package 10B according to some embodiments of the present disclosure. The second alternative semiconductor package 10B includes the module carrier 14, a flip-chip die 24 with a number of interconnections 24_I (only one interconnection is labeled with a reference number for clarity), an underfilling layer 26, and the thermally enhanced molding compound 12.

Herein, each interconnection 24_I extends from a lower surface of the flip-chip die 24 towards the upper surface of the module carrier 14, such that the flip-chip die 24 is formed over the upper surface of the module carrier 14. The interconnections 24_I are configured to electrically and thermally connect the flip-chip die 24 to the module carrier 14. The flip-chip die 24 may be produced from GaN and/or GaAs for high speed and high power applications. The interconnects 24_I with a height between 5 µm and 200 µm may be copper pillar bumps, solder ball bumps, or the like.

The underfilling layer 26 resides over the upper surface of the module carrier 14, such that the underfilling layer 26 encapsulates sides of each interconnect 24_I and underfills the flip-chip die 24 between the lower surface of the flip-chip die 24 and the upper surface of the module carrier 14. The underfilling layer 26 is configured to mitigate the stress effects caused by Coefficient of Thermal Expansion (CTE) mismatch between the flip-chip die 24 and the module carrier 14.

The thermally enhanced molding compound 12 resides over the underfilling layer 26 and encapsulates the flip-chip die 24 with the underfilling layer 26. In one embodiment, the underfilling layer 26 may be formed of a same material as the molding compound 18 without the thermal additive 20. In one embodiment, the underfilling layer 26 is a portion of the thermally enhanced molding compound 12 and is formed from the molding compound 18 mixed with the thermal additive 20. Within the thermally enhanced molding compound 12 of the second alternative semiconductor package 10B, the thermal additive 20 may be dispersed throughout the molding compound 18 with a substantially uniform density or a varied density. For instance, the density of the thermal additive 20 in first portions of the thermally enhanced molding compound 12, which are next to an upper surface of the flip-chip die 24 and underneath the lower surface of the flip-chip die 24 (i.e., the underfilling layer 26), is greater than the density of the thermal additive 20 in second portions of the thermally enhanced molding compound 12, which are located at the top and periphery of the semiconductor package 10. In some applications, only portions of the thermally enhanced molding compound 12 include the thermal additive 20. For instance, only the portions of the thermally enhanced molding compound 12 next to the upper surface of the flip-chip die 24 and next to the lower surface of the flip-chip die 24 (i.e., the underfilling layer 26) include the thermal additive 20.

Therefore, from one perspective, there has been described a semiconductor package with a thermally enhanced molding compound. The disclosed semiconductor package includes a module carrier having an upper surface, a die formed over the upper surface of the module carrier, and a thermally enhanced molding compound component formed over the upper surface of module carrier to encapsulate the die. Herein, the thermally enhanced molding compound is formed from a molding compound mixed with a thermal additive and has no air pockets or voids. The thermal additive includes a number of carbon flakes or a number of carbon spherical particles. The thermal additive has a thermal conductivity larger than 450 W/m K and an electrical resistivity larger than 90 µΩ.cm. In one embodiment, the thermal additive includes a number of graphene flakes, a number of graphene particles, a number of graphite flakes, or a number of graphite particles.

Further examples are set out in the following numbered clauses:
Clause 1. A semiconductor package comprising: a module carrier having an upper surface; a die formed over the upper surface of the module carrier; and a thermally enhanced molding compound formed over the upper surface of module carrier to encapsulate the die, wherein: the thermally enhanced molding compound is formed from a molding compound mixed with a thermal additive and has no air pockets or voids; the thermal additive includes a plurality of carbon flakes or a plurality of carbon spherical particles; and the thermal additive has a thermal conductivity larger than 450 W/m K and an electrical resistivity larger than 90 µΩ.cm.
Clause 2. The semiconductor package of clause 1 wherein the thermal additive includes a plurality of graphene flakes.
Clause 3. The semiconductor package of clause 1 or 2 wherein the thermal additive includes a plurality of graphene particles.
Clause 4. The semiconductor package of clause 1, 2 or 3 wherein the thermal additive includes a plurality of graphite flakes.
Clause 5. The semiconductor package of any of clauses 1 to 4 wherein the thermal additive includes a plurality of graphite particles.
Clause 6. The semiconductor package of any of clauses 1 to 5 wherein the thermal additive includes the plurality of carbon flakes, each of which has a maximum dimension of up to 50 µm in three dimensions.
Clause 7. The semiconductor package of clause 6 wherein each of the plurality of carbon flakes has a maximum dimension between 10 µm and 20 µm.
Clause 8. The semiconductor package of any of clauses 1 to 8 wherein the thermal additive includes the plurality of carbon spherical particles, each of which has a maximum dimension of up to 30 µm in three dimensions.
Clause 9. The semiconductor package of clause 8 wherein each of the plurality of carbon spherical particles has a maximum dimension between 10 µm and 20 µm.
Clause 10. The semiconductor package of any of clauses 1 to 9 wherein the die is produced from Gallium Nitride (GaN) and/or Gallium Arsenide (GaAs).
Clause 11. The semiconductor package of any of clauses 1 to 10 wherein the die is a wire-bonding die.
Clause 12. The semiconductor package of clause 11 further includes a polymer layer directly and fully covering the die, wherein the thermally enhanced molding compound is in contact with the polymer layer.
Clause 13. The semiconductor package of clause 12 wherein the polymer layer has a thickness up to 10 µm and is configured to protect the die and release stress of the die.
Clause 14. The semiconductor package of clause 12 or 13 wherein the polymer layer is formed of one of a group consisting of poly benzo butene (BCB), poly benzo oxazol (PBO), and polyimide (PI).
Clause 15. The semiconductor package of any of clauses 1 to 14 wherein the die is a flip-chip die including a plurality of interconnections protruding from a lower surface of the die towards the upper surface of the module carrier.
Clause 16. The semiconductor package of clause 15 further comprising an underfilling layer that resides over the upper surface of the module carrier, encapsulates sides of each of the plurality of interconnects, and underfills the die between the lower surface of the die and the upper surface of the module carrier.
Clause 17. The semiconductor package of clause 16 wherein the underfilling layer is a portion of the thermally enhanced molding compound.
Clause 18. The semiconductor package of any of clauses 1 to 17 wherein the molding compound itself has a thermal conductivity between 0.8 W/m·K -1.0 W/m·K.
Clause 19. The semiconductor package of any of clauses 1 to 18 wherein the molding compound is an organic epoxy resin.
Clause 20. The semiconductor package of any of clauses 1 to 19 wherein within the thermally enhanced molding compound, the thermal additive is dispersed throughout the molding compound with a varied density.

It is contemplated that any of the foregoing aspects, and/or various separate aspects and features as described herein, may be combined for additional advantage. Any of the various embodiments as disclosed herein may be combined with one or more other disclosed embodiments unless indicated to the contrary herein.

Those skilled in the art will recognize improvements and modifications to the illustrative embodiments of the present disclosure. All such improvements and modifications are considered within the scope of the concepts disclosed herein and the claims that follow.

## Claims

1. A semiconductor package comprising:
• a module carrier having an upper surface;
• a die formed over the upper surface of the module carrier; and
• a thermally enhanced molding compound formed over the upper surface of module carrier to encapsulate the die, wherein:
• the thermally enhanced molding compound is formed from a molding compound mixed with a thermal additive and has no air pockets or voids;
• the thermal additive includes a plurality of carbon flakes or a plurality of carbon spherical particles; and
• the thermal additive has a thermal conductivity larger than 450 W/m·K and an electrical resistivity larger than 90 µΩ.cm.

2. The semiconductor package of claim 1 wherein the thermal additive includes one or more selected from the group comprising: a plurality of graphene flakes; a plurality of graphene particles; a plurality of graphite flakes; and a plurality of graphite particles.

3. The semiconductor package of claim 1 or 2 wherein the thermal additive includes the plurality of carbon flakes, each of which has a maximum dimension of up to 50 µm in three dimensions.

4. The semiconductor package of claim 3 wherein each of the plurality of carbon flakes has a maximum dimension between 10 µm and 20 µm.

5. The semiconductor package of any of claims 1 to 4 wherein the thermal additive includes the plurality of carbon spherical particles, each of which has a maximum dimension of up to 30 µm in three dimensions.

6. The semiconductor package of claim 5 wherein each of the plurality of carbon spherical particles has a maximum dimension between 10 µm and 20 µm.

7. The semiconductor package of any of claims 1 to 6 wherein the die is produced from Gallium Nitride (GaN) and/or Gallium Arsenide (GaAs).

8. The semiconductor package of any of claims 1 to 7 wherein the die is a wire-bonding die.

9. The semiconductor package of claim 8 further includes a polymer layer directly and fully covering the die, wherein the thermally enhanced molding compound is in contact with the polymer layer, for example wherein the polymer layer has a thickness up to 10 µm and is configured to protect the die and release stress of the die.

10. The semiconductor package of claim 9 wherein the polymer layer is formed of one of a group consisting of poly benzo butene (BCB), poly benzo oxazol (PBO), and polyimide (PI).

11. The semiconductor package of any of claims 1 to 10 wherein the die is a flip-chip die including a plurality of interconnections protruding from a lower surface of the die towards the upper surface of the module carrier.

12. The semiconductor package of claim 11 further comprising an underfilling layer that resides over the upper surface of the module carrier, encapsulates sides of each of the plurality of interconnects, and underfills the die between the lower surface of the die and the upper surface of the module carrier, and for example wherein the underfilling layer is a portion of the thermally enhanced molding compound.

13. The semiconductor package of any of claims 1 to 12 wherein the molding compound itself has a thermal conductivity between 0.8 W/m·K -1.0 W/m·K.

14. The semiconductor package of any of claims 1 to 13 wherein the molding compound is an organic epoxy resin.

15. The semiconductor package of any of claims 1 to 15 wherein within the thermally enhanced molding compound, the thermal additive is dispersed throughout the molding compound with a varied density.
